# EUROPEAN PATENT APPLICATION

(11) **EP 2 469 615 A2**
(43) Date of publication of application: **27.06.2012**
(21) Application number: 11191836.3
(22) Date of filing: 05.12.2011
(51) Int. Cl.: H01L 33/50, H01L 33/00

(54) **Method of applying phosphor to semiconductor light-emitting device**

(30) Priority: 03.12.2010 KR 20100122674
(71) Applicant: Samsung LED Co., Ltd., Gyeonggi-do, 443-743 (KR)
(72) Inventor: Yoo, Cheol-jun, Chungcheongnam-do (KR); Hong, Seong-jae, Gyeonggi-do (KR)
(74) Representative: Grünecker, Kinkeldey, Stockmair & Schwanhäusser

(57) **Abstract**

A method of applying a phosphor according to a light-emission characteristic of semiconductor light-emitting devices so as to increase a yield rate of manufacture with respect to a white light-emitting device chip, the method including the operations of testing light-emission characteristics of a plurality of light-emitting devices formed on a wafer; disposing a plurality of light-emitting devices having the same light-emission characteristics on a carrier substrate; applying a same phosphor to the plurality of light-emitting devices disposed on the carrier substrate; and separating the plurality of arrayed light-emitting devices. Thus, a white light-emitting device chip manufactured by using the method may emit almost the same white light.

## Description

### BACKGROUND

### 1. Field

The present disclosure relates to methods of applying a phosphor to a semiconductor light-emitting device, and more particularly, to methods of applying a phosphor according to a light-emission characteristic of semiconductor light-emitting devices so as to increase a yield rate of manufacture with respect to a white light-emitting device chip.

### 2. Description of the Related Art

A light-emitting diode (LED) is a semiconductor light-emitting device that converts an electrical signal into light by using a characteristic of a compound semiconductor. The semiconductor light-emitting device such as the LED is characterized in that a lifetime of the semiconductor light-emitting device is longer than other conventional light-emitting bodies, and the semiconductor light-emitting device uses a low voltage and small power is consumed. Also, the semiconductor light-emitting device is excellent in its fast response speed and shock resistance, and furthermore, the semiconductor light-emitting device may be small and lightweight. The semiconductor light-emitting device may generate rays respectively having different wavelengths according to the types and composition of semiconductors, so that it is possible to generate and use rays with different wavelengths according to necessity.

Recently, a fluorescent lamp or an incandescent lamp according to the related art is replaced by a lighting lamp that uses a white light-emitting device chip having a high brightness. For example, the white light-emitting device chip may be formed by applying a red, green, or yellow phosphor to a light-emitting device that emits blue or ultraviolet light.

The phosphor application may be performed by using a wafer level coating technique for directly applying a phosphor to a wafer whereon a plurality of light-emitting devices are formed. However, the wafer level coating technique may be used only for a structure in which light is emitted above the light-emitting devices. Also, a light-emission characteristic slightly varies among the light-emitting devices formed on the same wafer, so that, if the same phosphor is applied to the light-emitting devices, white light-emitting device chips formed thereof may emit white rays having different characteristics. Due to this, a yield rate of manufacture with respect to a white light-emitting device chip may be decreased.

### SUMMARY

Provided are methods of applying a phosphor to a semiconductor light-emitting device, whereby a uniform color characteristic may be achieved, and a yield rate of manufacture with respect to a white light-emitting device chip may be increased.

Additional aspects will be set forth in part in the description which follows and, in part, will be apparent from the description, or may be learned by practice of the presented embodiments.

According to an aspect of the present invention, a method of applying a phosphor to a light-emitting device includes the operations of testing light-emission characteristics of a plurality of light-emitting devices formed on a wafer; disposing a plurality of light-emitting devices having the same light-emission characteristics on a carrier substrate; applying a same phosphor to the plurality of light-emitting devices disposed on the carrier substrate; and separating the plurality of arrayed light-emitting devices.

The operation of testing the light-emission characteristics may include the operations of independently separating the plurality of light-emitting devices formed on the wafer from the wafer; and testing a light-emission characteristic of each of the plurality of separated light-emitting devices.

The light-emission characteristics may include a light-emission spectrum and brightness.

The carrier substrate may have an adhesion layer formed on a top surface of the carrier substrate, and the plurality of light-emitting devices may be disposed on the adhesion layer.

The adhesion layer may include a photosensitive adhesive (PSA) that is curable by ultraviolet (UV) light, and the carrier substrate may have transmittance with respect to the UV light.

The operation of separating the plurality of light-emitting devices may include the operations of hardening the adhesion layer by irradiating the UV light to a bottom surface of the carrier substrate; and separating each of the plurality of light-emitting devices by using a holder.

The carrier substrate may further have an adhesive layer disposed on a top surface of the adhesion layer, and the plurality of light-emitting devices may be arrayed on the adhesive layer.

The adhesive layer may include a first adhesive layer disposed on the adhesion layer, a photo-reflection layer disposed on the first adhesive layer, and a second adhesive layer disposed on the photo-reflection layer.

A white filler having thermal conductivity, or a filler coated by metal may be dispersed in the first adhesive layer, the photo-reflection layer may include a metal thin film, and the second adhesive layer may have light-transmittance.

The operation of applying the same phosphor may include the operations of disposing a stencil mask above the plurality of light-emitting devices; arranging a phosphor paste on the stencil mask; and pressurizing the phosphor paste by using a squeeze, and uniformly applying the phosphor paste to top surfaces and side surfaces of the plurality of light-emitting devices.

The stencil mask may include a mesh structure designed to allow the phosphor paste to pass through the mesh structure, a masking member for masking the mesh structure, and one or more openings formed in the masking member.

The masking member may function to prevent the phosphor from being applied to electrode pads and areas by masking the electrode pads formed on the top surfaces of the plurality of light-emitting devices, and the areas between the plurality of light-emitting devices.

The masking member may have a portion for contacting the carrier substrate, and another portion for contacting the electrode pads of each of the plurality of light-emitting devices, and a height of the portion for contacting the carrier substrate may be different from a height of the other portion for contacting the electrode pads of each of the plurality of light-emitting devices.

A plurality of openings that respectively correspond to the plurality of light-emitting devices may be formed in the masking member.

A size of each of the plurality of openings may be a value corresponding to a total sum of a size of each of the plurality of light-emitting devices and a thickness of the phosphor formed on side surfaces of each of the plurality of light-emitting devices.

The stencil mask may have an opening, and all of the plurality of light-emitting devices on the carrier substrate may be positioned in the opening.

The masking member may be formed only at positions corresponding to electrode pads formed on the top surfaces of the plurality of light-emitting devices.

The stencil mask may have a plurality of openings, and a plurality of light-emitting devices may be positioned in each of the plurality of openings.

The stencil mask may include a metal mask having an opening by which an inner portion is completely open.

The operation of applying the same phosphor may further include the operation of hardening the phosphor paste applied to the top surfaces and the side surfaces of the plurality of light-emitting devices.

The operation of applying the same phosphor may further include the operation of removing the phosphor applied to the electrode pads by irradiating a laser to positions of the electrode pads formed on the plurality of light-emitting devices.

The operation of applying the same phosphor may further include the operations of positioning a spray device above the plurality of light-emitting devices; applying a phosphor paste to top surfaces and side surfaces of the plurality of light-emitting devices according to a spray coating way by sequentially moving the spray device above the plurality of light-emitting devices; and hardening the phosphor paste applied to the top surfaces and the side surfaces of the plurality of light-emitting devices.

The phosphor paste may be formed by further adding a catalyst to a paste that is a mixture of a phosphor and a binder resin, whereby an average viscosity of the phosphor paste may be less than about 100 cps.

The operation of applying the same phosphor may further include the operations of disposing a release film having a phosphor film adhered thereon above the plurality of light-emitting devices; applying a phosphor to top surfaces and side surfaces of the plurality of light-emitting devices by completely adhering the phosphor film that is on the release film on surfaces of the plurality of light-emitting devices and the carrier substrate by performing a laminating process; and removing the phosphor applied to electrode pads that are formed on the top surfaces of the plurality of light-emitting devices.

Heat may be applied to the phosphor film while the laminating process is performed.

The laminating process may be performed in a vacuum atmosphere.

The release film may include a plastic material comprising polyethylene terephthalate (PET) or polyvinyl chloride (PVC).

The phosphor film may be formed by disposing a liquid thermocurable resin on the release film, dispersing one or more types of phosphors in the thermocurable resin, and then by partially hardening the thermocurable resin.

The operation of removing the phosphor may include the operations of disposing a mask on the plurality of light-emitting devices, wherein the mask has a pattern of a plurality of openings at positions corresponding to the electrode pads; and removing the phosphor applied to the electrode pads by irradiating UV light to the electrode pads through the mask.

The phosphor film on the release film may be patterned to have openings at positions corresponding to the electrode pads formed on the top surfaces of the plurality of light-emitting devices.

The release film may be disposed to allow the phosphor film on the release film to face the plurality of light-emitting devices.

According to another aspect of the present invention, a method of applying a phosphor to a light-emitting device includes the operations of testing light-emission characteristics of a plurality of light-emitting devices formed on a wafer; arranging a release film whereon a phosphor film is adhered; disposing and adhering a plurality of light-emitting devices having the same light-emission characteristics on the phosphor film on the release film; disposing the plurality of light-emitting devices having the phosphor film adhered thereto on a carrier substrate; applying a phosphor to top surfaces and side surfaces of the plurality of light-emitting devices by completely adhering the phosphor film that is on the release film on surfaces of the plurality of light-emitting devices and the carrier substrate by performing a laminating process; and separating each of the plurality of light-emitting devices.

According to another aspect of the present invention, a method of applying a phosphor to a light-emitting device includes the operations of testing light-emission characteristics of a plurality of light-emitting devices formed on a wafer; arranging a carrier substrate whereon a phosphor film is adhered; disposing and adhering a plurality of light-emitting devices having the same light-emission characteristics on the phosphor film on the carrier substrate; separating each of the plurality of light-emitting devices, and the phosphor film adhered on the plurality of light-emitting devices from the carrier substrate; arranging each of the plurality of light-emitting devices on a base substrate; and applying a phosphor to top surfaces and side surfaces of the plurality of light-emitting devices by pressing the phosphor film adhered on the top surfaces of the plurality of light-emitting devices arranged on the base substrate.

The carrier substrate may have an adhesion layer formed on a top surface of the carrier substrate, and the phosphor film may be adhered on the adhesion layer.

A collet having a cavity with a shape corresponding to an outer frame shape of each of the plurality of light-emitting devices may press down the phosphor film, each of the plurality of light-emitting devices may be accepted into the cavity of the collet, and the phosphor film may be pressed down by the collet, whereby the phosphor may be applied to the top surfaces and the side surfaces of the plurality of light-emitting devices.

### BRIEF DESCRIPTION OF THE DRAWINGS

These and/or other aspects will become apparent and more readily appreciated from the following description of the embodiments, taken in conjunction with the accompanying drawings of which:

FIG. 1 illustrates a pattern of a plurality of semiconductor light-emitting device chips formed on a wafer substrate;

FIG. 2 illustrates a case in which semiconductor light-emitting device chips having the same light-emission characteristics are re-arrayed on a same carrier substrate;

FIG. 3 illustrates a method of applying a phosphor by performing screen printing, according to an embodiment of the present invention;

FIG. 4 illustrates an exemplary structure of a stencil mask;

FIG. 5 is a cross-sectional view of a structure of the stencil mask;

FIG. 6 illustrates a structure of a stencil mask according to another embodiment of the present invention;

FIG. 7 illustrates a case in which semiconductor light-emitting device chips are re-arrayed according to another embodiment of the present invention;

FIG. 8 illustrates a structure of a stencil mask according to another embodiment of the present invention;

FIG. 9 illustrates a method of applying a phosphor by performing screen printing, according to another embodiment of the present invention;

FIG. 10 is a cross-sectional view illustrating a structure of a carrier substrate having an adhesion layer and an adhesive layer with a multi-layered structure;

FIG. 11 illustrates a phosphor applying method according to another embodiment of the present invention;

FIG. 12 illustrates a process in which a phosphor formed on electrode pads of semiconductor light-emitting device chips is removed by laser irradiation;

FIG. 13 illustrates a dicing process performed when a phosphor is completely formed between semiconductor light-emitting device chips;

FIG. 14 illustrates a phosphor applying method according to another embodiment of the present invention;

FIG. 15 illustrates a phosphor applying method according to another embodiment of the present invention;

FIG. 16 illustrates a structure of a stencil mask according to another embodiment of the present invention;

FIG. 17 illustrates a phosphor applying method according to another embodiment of the present invention;

FIG. 18 illustrates a phosphor applying method according to another embodiment of the present invention;

FIG. 19 illustrates a phosphor applying method according to another embodiment of the present invention;

FIG. 20 illustrates a phosphor applying method according to another embodiment of the present invention;

FIG. 21 illustrates a phosphor applying method according to another embodiment of the present invention; and

FIGS. 22 and 23 illustrate a phosphor applying method according to another embodiment of the present invention.

### DETAILED DESCRIPTION

Reference will now be made in detail to embodiments, examples of which are illustrated in the accompanying drawings, wherein like reference numerals refer to the like elements throughout and the size of each component may be exaggerated for clarity. In this regard, the present embodiments may have different forms and should not be construed as being limited to the descriptions set forth herein. Accordingly, the embodiments are merely described below, by referring to the figures, to explain aspects of the present description.

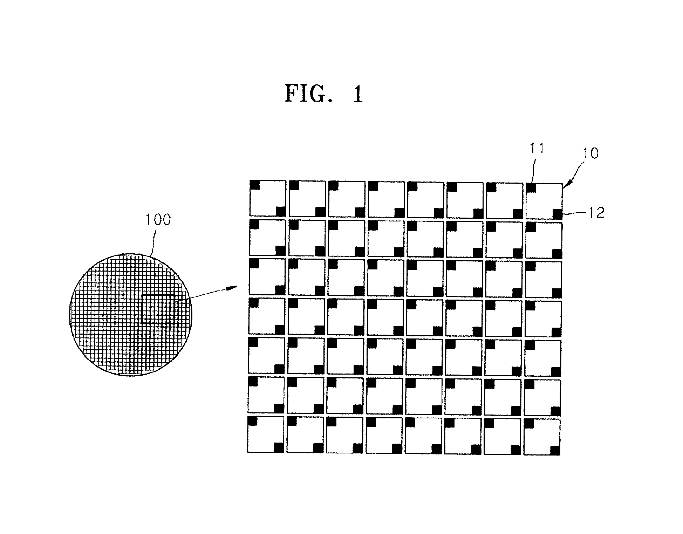

FIG. 1 illustrates a pattern of a plurality of semiconductor light-emitting device chips 10 formed on a wafer substrate 100 including sapphire. As illustrated in FIG. 1, in general, the semiconductor light-emitting device chips 10 may be arrayed in a rectangular-shape lattice on the wafer substrate 100. The semiconductor light-emitting device chips 10 may be formed on the wafer substrate 100 by performing, but not limited thereto, one of well-known processes. One or more electrode pads 11 and 12 for electrical connection may be formed on a top surface of each semiconductor light-emitting device chip 10. FIG. 1 illustrates a case in which two electrode pads 11 and 12, that is, an N-type electrode pad 11 and a P-type electrode pad 12 are formed on a top surface of each semiconductor light-emitting device chip 10. For example, as illustrated in FIG. 1, the repetitive two electrode pads 11 and 12 may be disposed at respective corners facing each other in a diagonal direction.

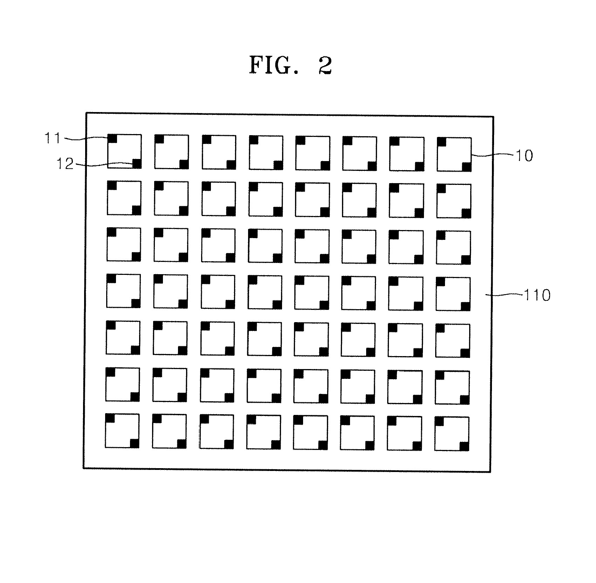

The semiconductor light-emitting device chips 10 arrayed on the wafer substrate 100 are independently separated from the wafer substrate 100 and then respective operating characteristics of the respective semiconductor light-emitting device chips 10 are tested. For example, the operating characteristic may include a light-emission spectrum, brightness, a response speed, a driving voltage, or the like. According to a result of the test, the semiconductor light-emitting device chips 10 may be classified into various categories. Afterward, the semiconductor light-emitting device chips 10 having the same light-emission characteristics with respect to a light-emission spectrum or brightness may be re-arrayed on the same carrier substrate 110, as illustrated in FIG. 2. While FIG. 2 illustrates a case in which 56 semiconductor light-emitting device chips 10 are re-arrayed on the carrier substrate 110, the case of FIG. 2 is exemplary and thus the number of the semiconductor light-emitting device chips 10 re-arrayed on the carrier substrate 110 is not limited thereto. A gap between the re-arrayed semiconductor light-emitting device chips 10 may be determined by a thickness of each semiconductor light-emitting device chip 10 and a dicing width. For example, the gap between the re-arrayed semiconductor light-emitting device chips 10 may be from about 50 um to about 500 um.

After the semiconductor light-emitting device chips 10 are re-arrayed on the carrier substrate 110, a phosphor is applied thereto so as to surround the semiconductor light-emitting device chips 10. The phosphor may be appropriately selected according to a light-emission characteristic of the semiconductor light-emitting device chips 10. For example, a phosphor may be selected according to a light-emission characteristic of the semiconductor light-emitting device chips 10, so that light emitted from each semiconductor light-emitting device chip 10 may excite the phosphor and then white light having a predetermined spectrum may be generated. Thus, according to the present embodiment, a phosphor that matches with a light-emission characteristic of each semiconductor light-emitting device chip 10 is selected and applied thereto, so that, after manufacture is complete, irregularities in light-emitting qualities of white light-emitting device chips may be reduced. Hereinafter, various methods of applying a phosphor to the semiconductor light-emitting device chips 10 re-arrayed on the carrier substrate 110 are described in detail.

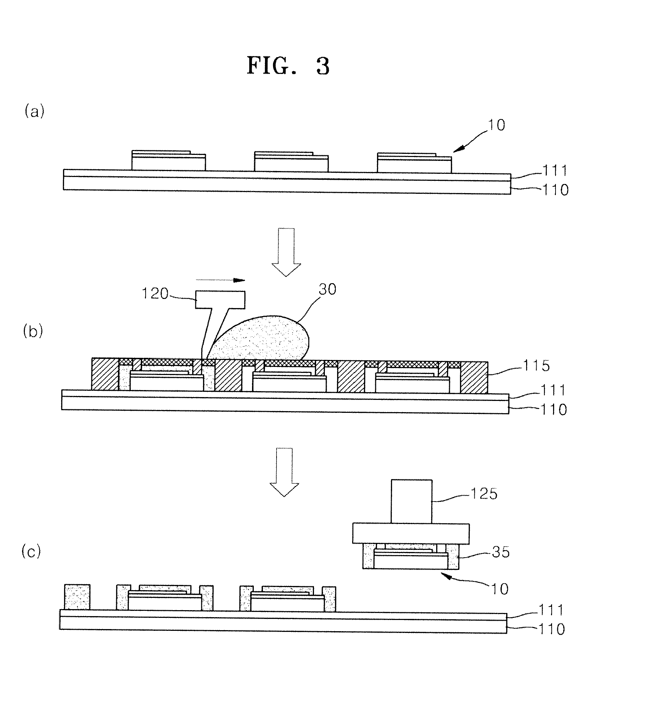

FIG. 3 illustrates a method of applying a phosphor by performing screen printing, according to an embodiment of the present invention. Referring to FIG. 3 (a), first, an adhesion layer 111 is formed on the carrier substrate 110, and the semiconductor light-emitting device chips 10 having the same light-emission characteristics are arrayed on the adhesion layer 111 at regular gaps. The adhesion layer 111 functions to assure positional stability of the semiconductor light-emitting device chips 10 arrayed on the carrier substrate 110. For example, the adhesion layer 111 may be formed of a photosensitive adhesive (PSA) that is curable by ultraviolet (UV) light. The carrier substrate 110 may be formed as a flexible film that is easily bent or may be formed as a solid flat plate. In a case where the adhesion layer 111 is formed of the PSA, the carrier substrate 110 may be formed of a UV-transmitting material. However, if the semiconductor light-emitting device chips 10 may be stably fixed on a surface of the carrier substrate 110, the adhesion layer 111 may be omitted.

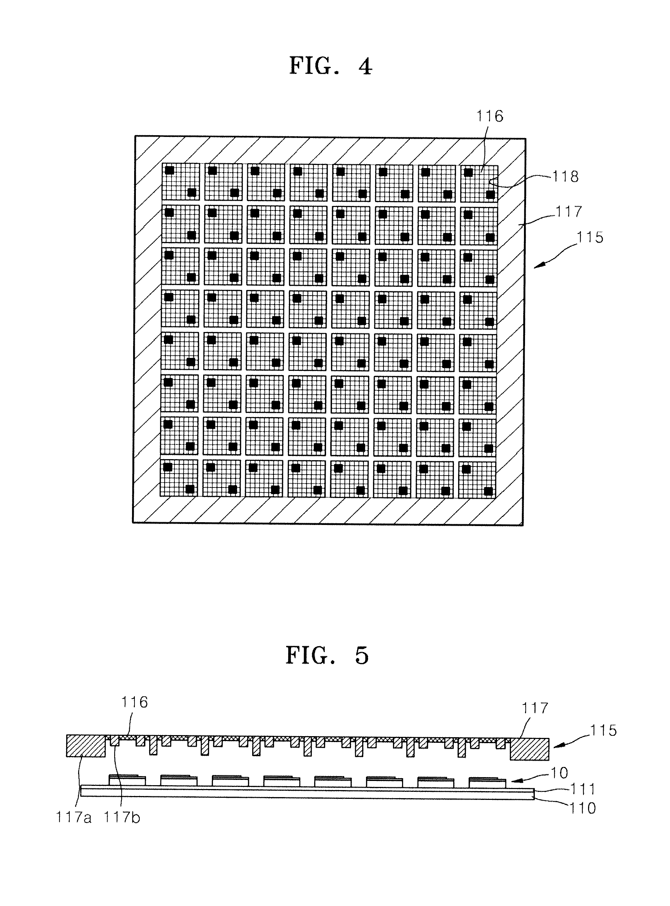

Next, referring to FIG. 3 (b), a stencil mask 115 for screen printing may be disposed on the semiconductor light-emitting device chips 10 arranged on the carrier substrate 110. As illustrated in FIG. 4, the stencil mask 115 may include a mesh structure 116 formed of steel use stainless (SUS), and a masking member 117 formed to mask the mesh structure 116. A surface of the mesh structure 116 may be further coated by using metal including chromium (Cr), nickel (Ni), palladium (Pd), copper (Cu), gold (Au), aluminum (AI), or the like, in order that the phosphor can easily pass through the mesh structure 116. The masking member 117 may be formed of a polymer or a metal thin film. Referring to FIG. 4, the masking member 117 functions to mask the electrode pads 11 and 12 formed on the top surface of each semiconductor light-emitting device chip 10, and to mask gaps between the semiconductor light-emitting device chips 10, so that the masking member 117 prevents the phosphor from being applied thereto. The masking member 117 has a plurality of openings 118 so as to allow the phosphor to be applied only to a top emission surface and four side surfaces of each semiconductor light-emitting device chip 10. In order to apply the phosphor to the side surfaces of each semiconductor light-emitting device chip 10, each opening 118 of the masking member 117 may have a size that is slightly greater than a size of each semiconductor light-emitting device chip 10. Thus, the size of each opening 118 may be a value corresponding to the total sum of the size of each semiconductor light-emitting device chip 10 and a thickness of the phosphor that is formed on a side surface of each semiconductor light-emitting device chip 10. For example, the thickness of the phosphor formed on the side surface of each semiconductor light-emitting device chip 10 may be between about 20 um and about 100 um, so that the size of each opening 118 may be vertically and horizontally greater than the size of each semiconductor light-emitting device chip 10 by about 20 um through about 100 um. Also, a gap between the openings 118 may be the same as a gap between phosphors that are applied to facing surfaces of the semiconductor light-emitting device chips 10. For example, the gap between the openings 118, that is, the gap between the phosphors may be from about 40 um to about 200 um.

A portion of a bottom surface of the masking member 117 contacts the adhesion layer 111 of the carrier substrate 110, and the other portion of the bottom surface contacts the electrode pads 11 and 12 of each semiconductor light-emitting device chip 10. For example, referring to FIG. 5 that is a cross-sectional view of a structure of the stencil mask 115, a first portion 117a of the masking member 117 contacts the adhesion layer 111 of the carrier substrate 110, and a second portion 117b contacts the electrode pads 11 and 12 of each semiconductor light-emitting device chip 10. Thus, the first portion 117a and the second portion 117b have different heights. By using the masking member 117 having two heights, the top emission surface and the four side surfaces of each semiconductor light-emitting device chip 10, except for the electrode pads 11 and 12 of each semiconductor light-emitting device chip 10, may be simultaneously applied by using the phosphor.

Referring back to FIG. 3 (b), when the stencil mask 115 is disposed on the semiconductor light-emitting device chips 10, a phosphor paste 30 is arranged on the stencil mask 115. Afterward, the phosphor paste 30 is pushed and pressed by using a squeeze 120. Then, the phosphor paste 30 passes through the mesh structure 116 in each opening 118 of the stencil mask 115, so that the phosphor paste 30 is uniformly applied to the top emission surface and the four side surfaces of each semiconductor light-emitting device chip 10. The squeeze 120 may be formed of a plastic material so as to prevent a metal particle from being generated by friction against the metal that forms the masking member 117. For example, the squeeze 120 may be formed of urethane, acryl, or polycarbonate, or may be formed of an engineering plastic material, including nylon or the like, which has a high abrasion-resistance and excellent mechanical properties.

The phosphor paste 30 may be formed by mixing a resin and one or more types of phosphors according to a predetermined mixing ratio. The types of phosphors and the mixing ratio may be selected according to a light-emission characteristic of the semiconductor light-emitting device chips 10. The resin may be formed of a polymer material having characteristics including high adhesion, high heat-resistance, low hygroscopic properties, and high light-transmittance, and in general, the resin is formed of an epoxy-based curable resin or a silicon-based curable resin. A curing system of the resin may be thermally curable or photocurable, or a combination of thermally curable and photocurable.

After the phosphor paste 30 is uniformly applied to the top emission surface and the four side surfaces of each semiconductor light-emitting device chip 10, the phosphor paste 30 may be hardened by applying heat or light thereto. Afterward, as illustrated in FIG. 3 (c), a phosphor layer 35 may be formed on the top surface and side surfaces of each semiconductor light-emitting device chip 10. Next, the stencil mask 115 is removed, and the semiconductor light-emitting device chips 10 on the carrier substrate 110 may be independently separated by using a holder 125. In a case where the adhesion layer 111 is formed of a PSA that is curable by UV light, before the semiconductor light-emitting device chips 10 are separated, the UV light is irradiated to a bottom surface of the carrier substrate 110 to harden the adhesion layer 111. In this case, when the adhesion layer 111 is hardened, the semiconductor light-emitting device chips 10 may be further easily separated. In a subsequent process, each of the separated semiconductor light-emitting device chips 10 is packaged to manufacture a white light-emitting device chip.

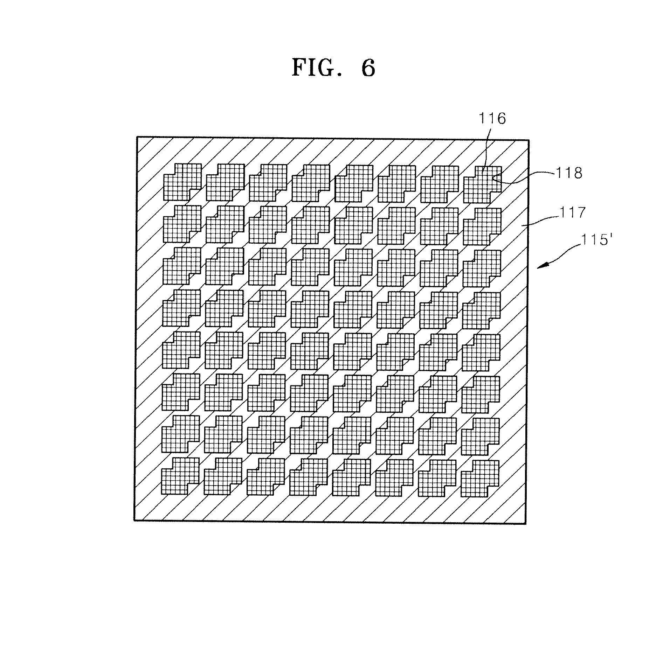

A shape of the stencil mask 115 illustrated in FIG. 4 may vary. For example, FIG. 6 illustrates a stencil mask 115' according to another embodiment of the present invention. In the stencil mask 115 of FIG. 4, the masking member 117 is divided into a region for masking the electrode pads 11 and 12, and a region for masking a gap between the semiconductor light-emitting device chips 10. That is, the masking member 117 for masking the electrode pads 11 and 12 is separately arranged in the opening 118. On the other hand, in the stencil mask 115' of FIG. 6, the masking member 117 extends to regions corresponding to the electrode pads 11 and 12 via corners of each opening 118. The stencil mask 115' of FIG. 6 further easily masks the electrode pads 11 and 12, thereby preventing a phosphor from being applied to a portion of the electrode pads 11 and 12.

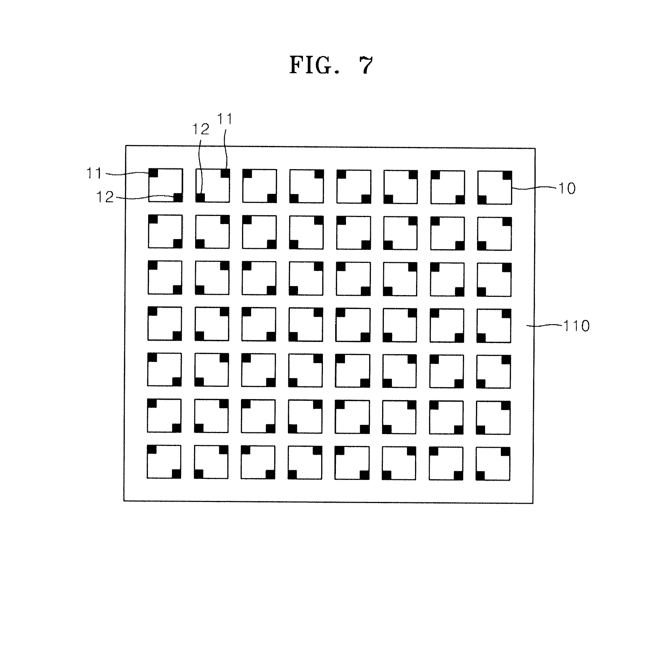

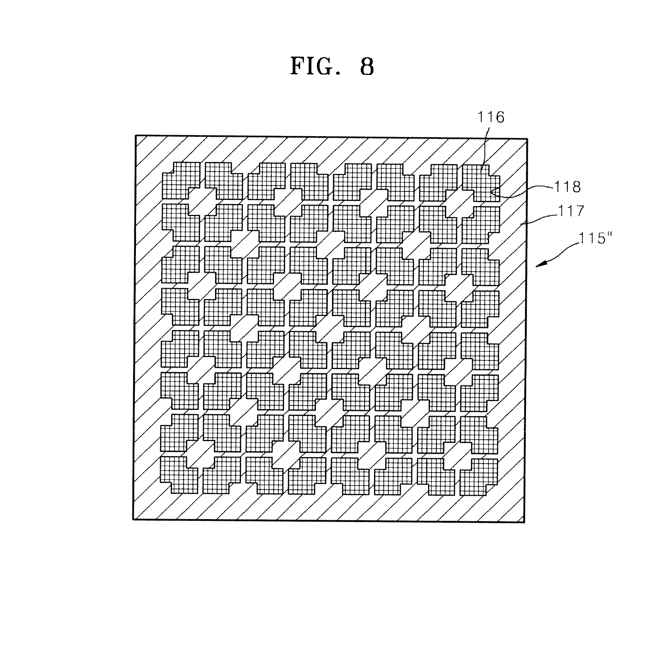

Referring to FIG. 2, the semiconductor light-emitting device chips 10 are arrayed in the same direction on the carrier substrate 110, but an array direction of the semiconductor light-emitting device chips 10 may vary. For example, FIG. 7 illustrates a case in which adjacent semiconductor light-emitting device chips 10 are arrayed in different directions. Referring to the case of FIG. 7, compared to an array of FIG. 2, the semiconductor light-emitting device chips 10 on even rows of an odd column are rotated by 90 degrees in a left direction, and the semiconductor light-emitting device chips 10 on odd rows of an even column are rotated by 90 degrees in a left direction. Thus, in an entire array, the electrode pads 11 and 12 are gathered at respective corners and face each other. This array further facilitates formation of a masking member. For example, FIG. 8 illustrates a stencil mask 115" according to another embodiment of the present invention. The stencil mask 115" of FIG. 8 may be used in the array of FIG. 7. In the case of FIG. 7, four electrode pads 11 and 12 are gathered at respective corners and face each other, so that a region of the masking member 117 which masks the electrode pads 11 and 12 may be largely formed in a center among four openings 118. Thus, referring to a case of FIG. 8, it is further easy to form the masking member 117.

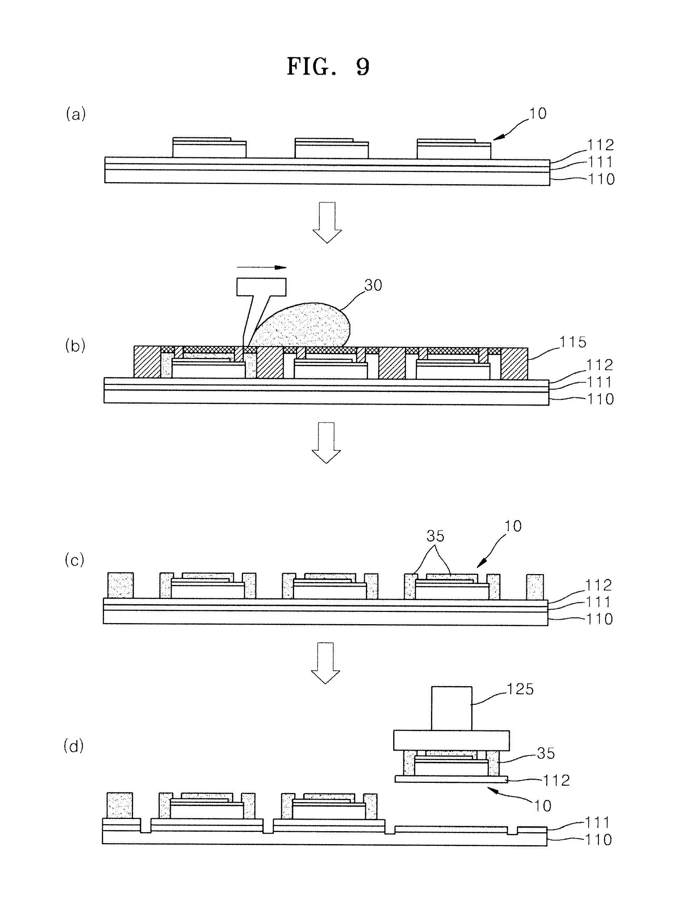

FIG. 9 illustrates a method of applying a phosphor by performing screen printing, according to another embodiment of the present invention. Referring to FIG. 9 (a), first, an adhesion layer 111 and an adhesive layer 112 are sequentially formed on a carrier substrate 110. Then, semiconductor light-emitting device chips 10 having the same light-emission characteristics are arrayed on the adhesive layer 112 at regular gaps. The adhesion layer 111 functions to temporarily fix the adhesive layer 112 thereon. As described above, the adhesion layer 111 may be formed of a PSA that is curable by UV light. Also, as described above, the carrier substrate 110 may be formed as a flexible film that is easily bent or may be formed as a solid flat plate. In a case where the adhesion layer 111 is formed of the PSA, the carrier substrate 110 may be formed of a UV-transmitting material.

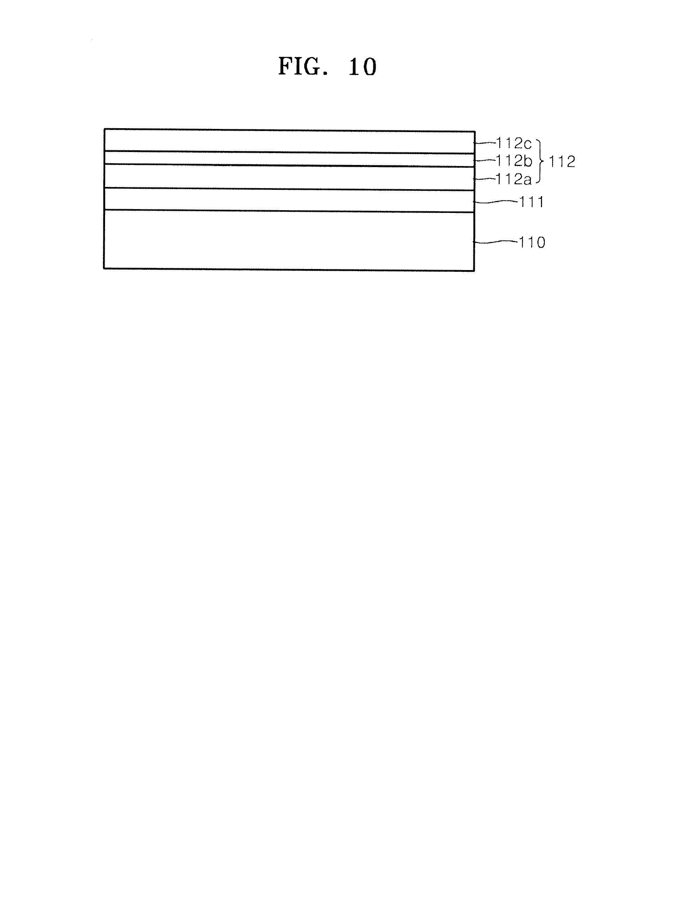

The adhesive layer 112 may be a single layer formed of the same material but may be a multi-layer structure having different layers. FIG. 10 is a cross-sectional view illustrating the carrier substrate 110, the adhesion layer 111, and a multi-layered structure of the adhesive layer 112. Referring to FIG. 10, the adhesion layer 111 and the adhesive layer 112 are disposed on the carrier substrate 110. The adhesive layer 112 may include a first adhesive layer 112a, a photo-reflection layer 112b, and a second adhesive layer 112c that are sequentially formed on the adhesion layer 111. In this case, the semiconductor light-emitting device chips 10 may be arrayed on the second adhesive layer 112c. The adhesive layer 112 may have high reflectance so as to reflect light emitted from a lower portion of the semiconductor light-emitting device chips 10, and may have heat-resistance and thermal conductivity so as to resist and deliver heat, which is generated from the semiconductor light-emitting device chips 10, to the outside. Also, the adhesive layer 112 may have high adhesion to the semiconductor light-emitting device chips 10.

In a case where the adhesive layer 112 is formed as a single layer, a filler such as white titanium oxide (TiO₂) may be dispersed in an adhesive resin. Also, a filler coated by metal including Ag or Al having high reflectance may be dispersed in the adhesive resin. The filler may function to reflect light and to increase thermal conductivity by forming a thermal path in the adhesive layer 112. In a case where the adhesive layer 112 is formed as a multi-layer structure having the aforementioned three layers, the second adhesive layer 112c contacting the semiconductor light-emitting device chips 10 may be formed of a transparent adhesive material having high light-transmittance so as to transmit light emitted from the semiconductor light-emitting device chips 10. The photo-reflection layer 112b may be a high reflective metal thin film coated on a top surface of the first adhesive layer 112a or a bottom surface of the second adhesive layer 112c. For example, the photo-reflection layer 112b may be formed of a metal material including Ag or AI, and may have a thickness in the range several tens nm to several um. The first adhesive layer 112a arranged below the photo-reflection layer 112b and contacting the adhesion layer 111 is not required to have light-transmittance, so that the first adhesive layer 112a may be formed of an opaque adhesive material. The aforementioned fillers having high thermal conductivity may be dispersed in the first adhesive layer 112a. The first adhesive layer 112a and the second adhesive layer 112c may have the same thickness or may have different thicknesses.
In general, for heat radiation, the first adhesive layer 112a may have a thickness that is less than that of the second adhesive layer 112c.

After the semiconductor light-emitting device chips 10 are arrayed on the adhesive layer 112, as illustrated in FIG. 9 (b), a stencil mask 115 for screen printing is disposed on the semiconductor light-emitting device chips 10. A structure of the stencil mask 115 is the same as the descriptions above. After the stencil mask 115 is disposed on the semiconductor light-emitting device chips 10, a phosphor paste 30 is arranged on the stencil mask 115. Afterward, the phosphor paste 30 is pushed and pressed by using a squeeze 120, and by doing so, the phosphor paste 30 may be uniformly applied to top surfaces and side surfaces of the semiconductor light-emitting device chips 10.

Afterward, the phosphor paste 30 is hardened by applying heat or light thereto, and then the stencil mask 115 is removed. By doing so, as illustrated in FIG. 9 (c), a phosphor layer 35 may be formed on the top surface and the side surfaces of each semiconductor light-emitting device chip 10. Afterward, when the adhesive layer 112 arranged below each semiconductor light-emitting device chip 10 is cut by performing a dicing process, as illustrated in FIG. 9 (d), each semiconductor light-emitting device chip 10 may be separated from the carrier substrate 110 by using a holder 125. Here, the adhesive layer 112 is adhered on a bottom surface of each semiconductor light-emitting device chip 10. As described above, if the adhesion layer 111 is formed of a PSA that is curable by UV light, before the semiconductor light-emitting device chips 10 are separated, the UV light is irradiated to a bottom surface of the carrier substrate 110 to harden the adhesion layer 111. In this case, when the adhesion layer 111 is hardened, the semiconductor light-emitting device chips 10 may be further easily separated. In a subsequent process, each of the separated semiconductor light-emitting device chips 10 is packaged to manufacture a white light-emitting device chip.

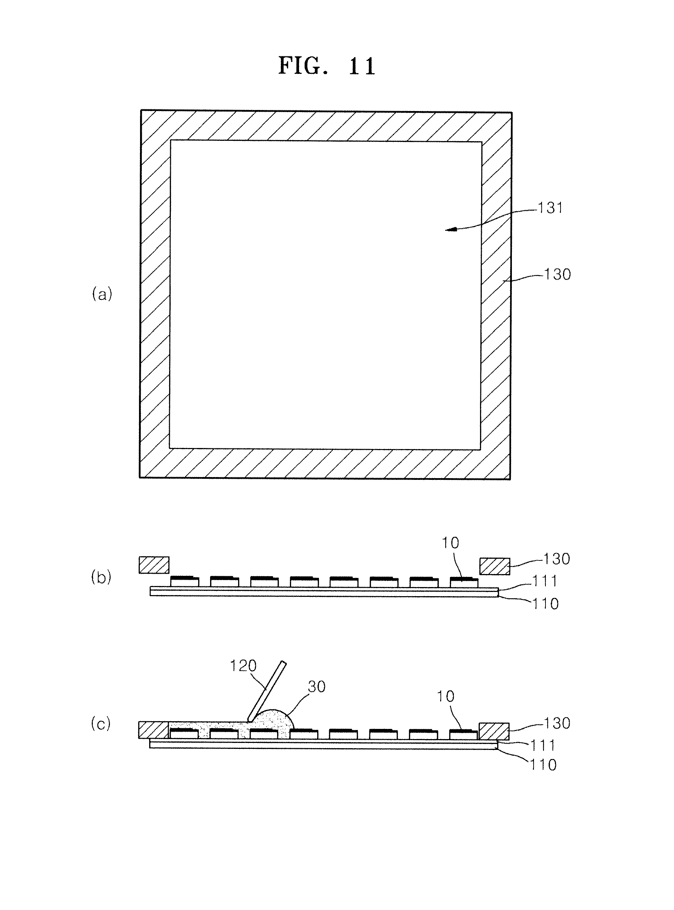

According to the one or more embodiments, the masking member 117 is formed in an area between the semiconductor light-emitting device chips 10, so that the phosphor is not applied to the area between the semiconductor light-emitting device chips 10. However, it is also possible to completely and uniformly apply the phosphor to the carrier substrate 110 whereon the semiconductor light-emitting device chips 10 are arrayed. In this regard, FIG. 11 illustrates a phosphor applying method, according to another embodiment of the present invention.

First, referring to FIG. 11 (a), a stencil mask 130 is illustrated, wherein the stencil mask 130 may be a metal mask having one opening 131 by which an inner portion is completely open. The opening 131 of the stencil mask 130 may correspond to an inner portion of a carrier substrate 110 whereon the semiconductor light-emitting device chips 10 having the same light-emission characteristics are arrayed. Referring to FIG. 11 (b), a frame portion of the stencil mask 130 may be disposed at side edges of the carrier substrate 110. Thus, all of the semiconductor light-emitting device chips 10 on the carrier substrate 110 may be positioned in the opening 131 of the stencil mask 130.

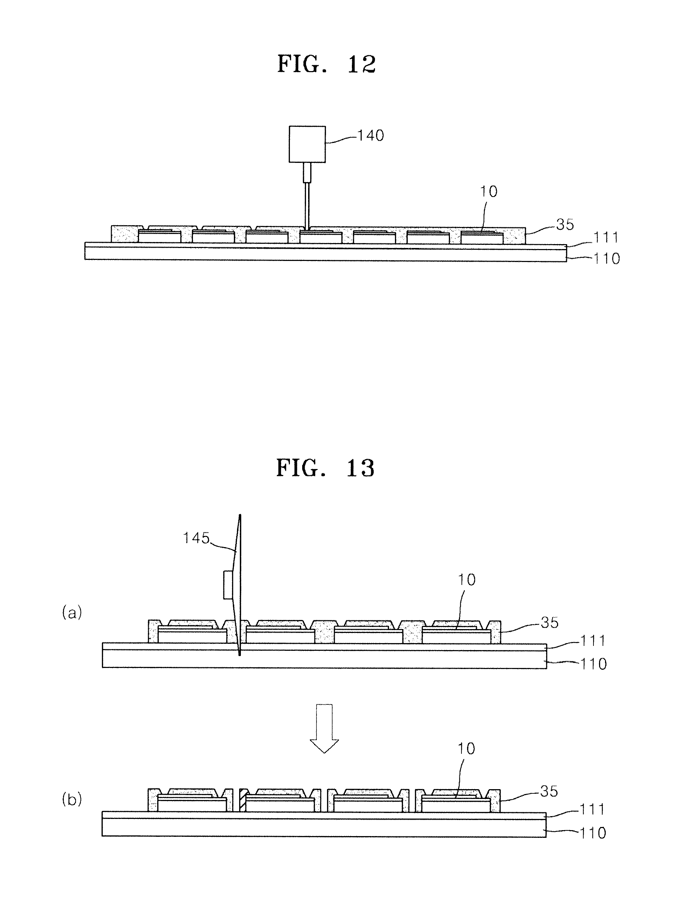

Afterward, as illustrated in FIG. 11 (c), a phosphor paste 30 is arranged in the opening 131. Afterward, the phosphor paste 30 is uniformly applied to the semiconductor light-emitting device chips 10 and the carrier substrate 110 by pushing the phosphor paste 30 with a squeeze 120. Here, the phosphor paste 30 may be applied to not only a top surface of each semiconductor light-emitting device chip 10 but also applied to an area between the semiconductor light-emitting device chips 10. Referring to FIG. 11 (c), only an adhesion layer 111 is disposed on the carrier substrate 110 but an adhesive layer 112 may be additionally formed on the adhesion layer 111. After the phosphor paste 30 is uniformly applied thereto, as described above, the phosphor paste 30 is hardened so that a phosphor layer 35 (refer to FIG. 12) may be formed. By doing so, the phosphor layer 35 may be formed not only on the top surface of each semiconductor light-emitting device chip 10 but also formed on the area between the semiconductor light-emitting device chips 10.

In the present embodiment, the phosphor layer 35 is also formed on electrode pads 11 and 12 that are formed on the top surface of each semiconductor light-emitting device chip 10, and thus, after formation of the phosphor layer 35 is complete, it is necessary to remove the phosphor layer 35 on the electrode pads 11 and 12. As illustrated in FIG. 12, the phosphor layer 35 may be removed by irradiating a laser to portions corresponding to the electrode pads 11 and 12. For this removal, a laser 140 that emits light having a wavelength band absorbed by a binder resin forming the phosphor paste 30 may be used. For example, in a case of a silicon resin binder that is widely used, a CO₂ laser having a wavelength most absorbed by a silicon resin may be used. In this manner, by irradiating the laser 140 to the portions corresponding to the electrode pads 11 and 12, the phosphor layer 35 on the electrode pads 11 and 12 is removed, so that the electrode pads 11 and 12 may be externally exposed.

Afterward, in a final process, the semiconductor light-emitting device chips 10 may be independently separated by performing a dicing process. In the present embodiment, the phosphor layer 35 is even formed between the semiconductor light-emitting device chips 10, so a blade may be used to separate the phosphor layer 35 in the dicing process. For example, referring to FIG. 13 (a), the phosphor layer 35 formed between the semiconductor light-emitting device chips 10 is cut by using a blade 145. The blade 145 may be a rotation-type blade that cuts the phosphor layer 35 while rotating, or may be a fix-type blade that presses the phosphor layer 35 with a sharp blade and then cuts the phosphor layer 35. In order to prevent contamination due to particles of the phosphor layer 35, which are generated during a cutting process, the phosphor layer 35 may be cut with zero kerf width. For this, the blade 145 may be a metal blade having undergone a treatment to improve a surface hardness. Also, instead of using the blade 145, the dicing process may be performed by using a laser. In FIG. 13 (b), the phosphor layer 35 is cut by using one of the aforementioned ways. Afterward, as described above, each semiconductor light-emitting device chip 10 may be separated from the carrier substrate 110 by using a holder 125.

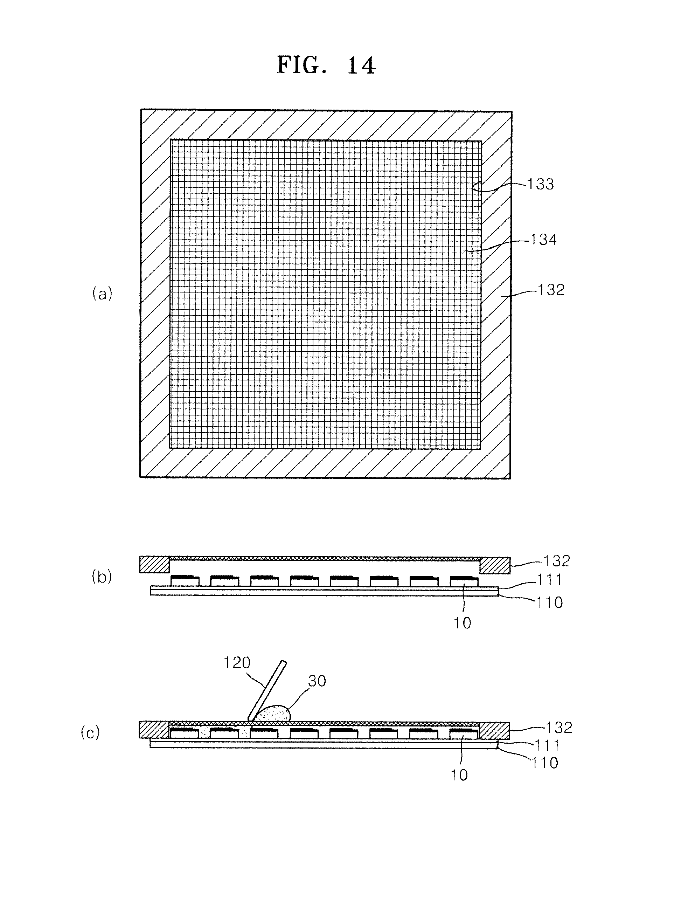

Instead of a metal mask, a mesh mask may also be used as a stencil mask, wherein the mesh mask has an opening in which a metal mesh is formed. FIG. 14 illustrates a method of applying a phosphor by using a mesh mask, according to another embodiment of the present invention. Referring to FIG. 14 (a), a mesh 134 is formed in an opening 133 of a stencil mask 132. Here, the opening 133 may correspond to an inner portion of a carrier substrate 110 whereon the semiconductor light-emitting device chips 10 having the same light-emission characteristics are arrayed. Referring to (b) of FIG. 14, a frame portion of the stencil mask 132 may be disposed at side edges of the carrier substrate 110. Thus, all of the semiconductor light-emitting device chips 10 on the carrier substrate 110 may be positioned in the opening 133 of the stencil mask 132.

Afterward, as illustrated in FIG. 14 (c), a phosphor paste 30 is arranged on the mesh 134. Afterward, the phosphor paste 30 is uniformly applied to the semiconductor light-emitting device chips 10 and the carrier substrate 110 by pushing the phosphor paste 30 through the mesh 134 by using a squeeze 120. Here, the phosphor paste 30 may be applied to not only a top surface of each semiconductor light-emitting device chip 10 but also applied to an area between the semiconductor light-emitting device chips 10. After the phosphor paste 30 is uniformly applied thereto, as described above, the phosphor paste 30 is hardened so that a phosphor layer 35 (refer to FIG. 12) may be formed. After the phosphor layer 35 is formed, as described above, according to processes shown in FIGS. 12 and 13, the phosphor layer 35 on electrode pads 11 and 12 is removed and then a dicing process may be performed.

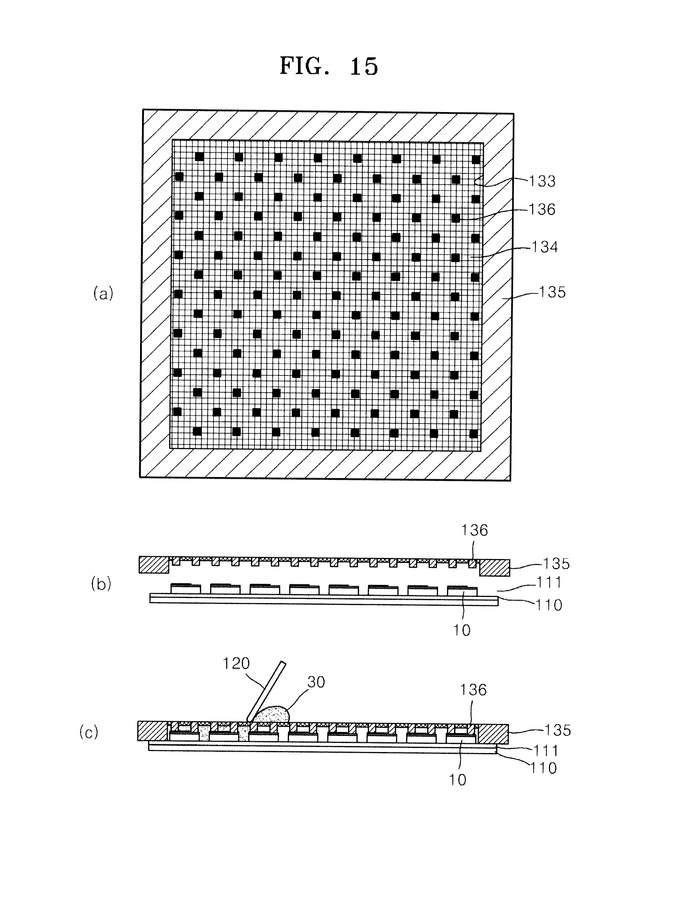

FIG. 15 illustrates a phosphor applying method according to another embodiment of the present invention. The embodiment of FIG. 15 is similar to the embodiment of FIG. 14 but is different in that masking members 136 are formed in a mesh 134 of a stencil mask 135 so as to mask electrode pads 11 and 12. Referring to FIG. 15 (a), similar to the stencil mask 132 of FIG. 14, the stencil mask 135 has an opening 133 and the mesh 134, and further has the masking members 136 functioning to mask the electrode pads 11 and 12. Positions of the masking members 136 may correspond to positions of the electrode pads 11 and 12 on semiconductor light-emitting device chips 10.

Thus, as illustrated in FIG. 15 (b) and (c), a phosphor paste 30 may be uniformly applied to a top surface of each semiconductor light-emitting device chip 10 and an area between the semiconductor light-emitting device chips 10 except for areas of the semiconductor light-emitting device chips 10 in which the electrode pads 11 and 12 are arranged. Here, each masking member 136 may have a height that is sufficient to directly contact the electrode pads 11 and 12 on each semiconductor light-emitting device chip 10. Afterward, a process of FIG. 12 is omitted, and a dicing process of FIG. 13 may be performed.

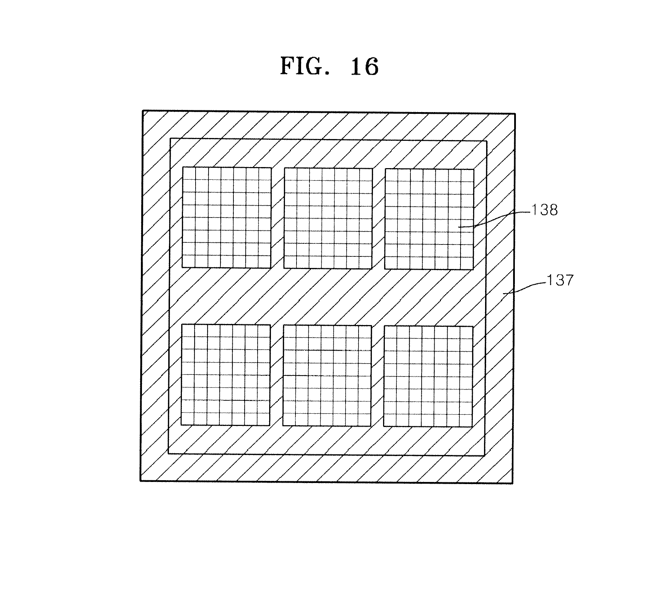

According to the embodiments of FIGS. 11, 14 and 15, each of the stencil masks 130, 132, and 135 has only one opening 131 or 133, but a stencil mask may have a plurality of openings corresponding to the semiconductor light-emitting device chips 10. For example, a stencil mask 137 of FIG. 16 has a plurality of openings 138. Referring to FIG. 16, a mesh mask has openings 138 each in which a mesh is formed. However, the plurality of openings may also be applied to a metal mask in which a mesh is not formed. In a case of the stencil mask 115 of FIG. 4, the plurality of openings 118 correspond to the semiconductor light-emitting device chips 10, respectively. However, in the stencil mask 137 of FIG. 16, one opening 138 may correspond to a plurality of the semiconductor light-emitting device chips 10. In a case where the stencil mask 137 of FIG. 16 is used, the semiconductor light-emitting device chips 10 may be grouped and arrayed so as to correspond to respective positions of the openings 138. That is, the semiconductor light-emitting device chips 10 may be divided into a plurality of groups, and then may be arrayed at positions of the openings 138 which correspond to the groups, respectively. By doing so, an area to be applied with a phosphor paste may be reduced so that the phosphor paste may be further uniformly applied thereto.

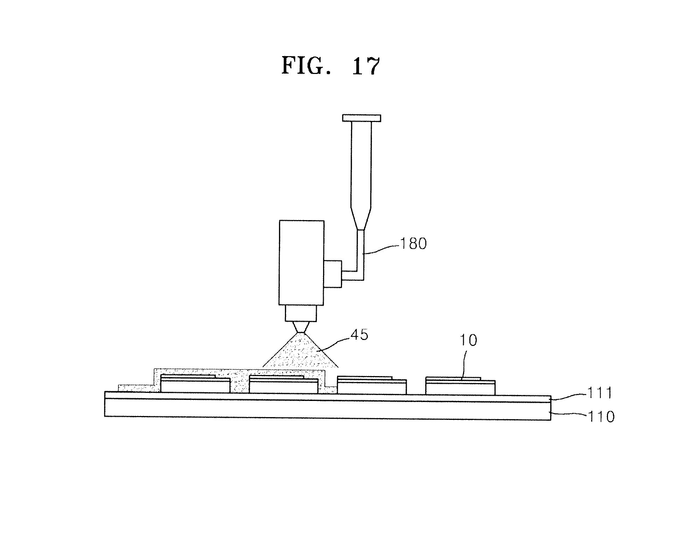

FIG. 17 illustrates a phosphor applying method according to another embodiment of the present invention. According to the phosphor applying method of FIG. 17, a phosphor paste is applied by using a spray coating method. Referring to FIG. 17, an adhesion layer 111 is formed on a carrier substrate 110, the semiconductor light-emitting device chips 10 having the same light-emission characteristics are arrayed on the adhesion layer 111 at regular gaps, and a spray device 180 is positioned above the semiconductor light-emitting device chips 10. While only the adhesion layer 111 is illustrated in FIG. 17, an adhesive layer 112 may also be formed on the adhesion layer 111. The spray device 180 sequentially moves above the semiconductor light-emitting device chips 10 and sprays a phosphor paste 45 on the semiconductor light-emitting device chips 10. By doing so, the phosphor paste 45 may be sprayed on top surfaces of the semiconductor light-emitting device chips 10, and areas between the semiconductor light-emitting device chips 10. Here, the phosphor paste 45 may be formed by further adding a catalyst to a paste that is a mixture of a phosphor and a binder resin, so that an average viscosity of the phosphor paste 45 may be less than about 100 cps. Afterward, as described above, the phosphor paste 45 is hardened so as to form a phosphor layer 35, and as illustrated in FIGS. 12 and 13, the phosphor layer 35 on the electrode pads 11 and 12 is removed and then a dicing process may be performed.

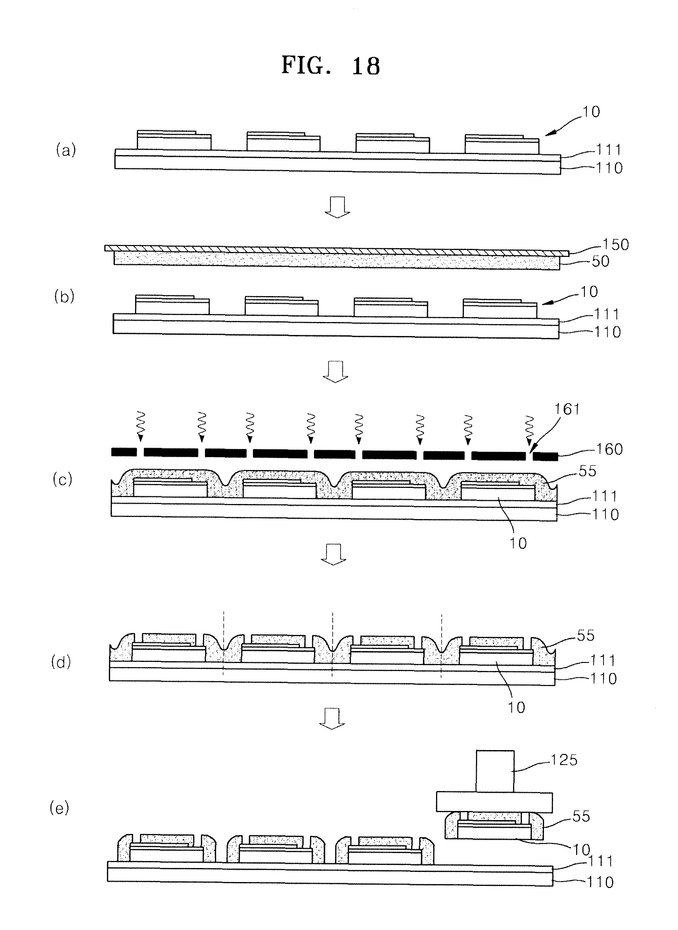

FIG. 18 illustrates a phosphor applying method according to another embodiment of the present invention. Referring to FIG. 18 (a), an adhesion layer 111 is formed on a carrier substrate 110, and semiconductor light-emitting device chips 10 having the same light-emission characteristics are arrayed on the adhesion layer 111 at regular gaps. Configurations and characteristics of the carrier substrate 110 and the adhesion layer 111 are the same as the descriptions above.

Afterward, as illustrated in FIG. 18 (b), a release film 150 having a phosphor film 50 adhered thereon is disposed above the semiconductor light-emitting device chips 10. Here, the release film 150 is disposed in such a manner that the phosphor film 50 adhered on the release film 150 faces the semiconductor light-emitting device chips 10. The release film 150 may be formed of a plastic material including polyethylene terephthalate (PET), polyvinyl chloride (PVC), or the like. The phosphor film 50 adhered on the release film 150 may be formed in a manner that a liquid thermocurable resin is disposed on the release film 150, one or more types of phosphors are dispersed in the thermocurable resin according to a predetermined mixture ratio, and then the thermocurable resin is partially hardened.

After the release film 150 is disposed above the semiconductor light-emitting device chips 10, the phosphor film 50 is completely adhered on surfaces of the semiconductor light-emitting device chips 10 and the carrier substrate 110 by performing a general laminating process. While the phosphor film 50 is adhered on the surfaces of the semiconductor light-emitting device chips 10 and the carrier substrate 110, the phosphor film 50 may be heated. By doing so, the phosphor film 50 may be easily moved from the release film 150 to the semiconductor light-emitting device chips 10 and the carrier substrate 110, and the phosphor film 50 may be easily deformed, so that adhesion of the phosphor film 50 may be improved. Afterward, the phosphor film 50 that detaches from the release film 150 and moves to the semiconductor light-emitting device chips 10 and the carrier substrate 110 may be hardened. This laminating process may be performed in a vacuum atmosphere. By doing so, it is possible to prevent the air from collecting on surfaces of the semiconductor light-emitting device chips 10, and an interface between a surface of the carrier substrate 110 and the phosphor film 50.

Afterward, as illustrated in FIG. 18 (c), a phosphor layer 55 may be formed surrounding top surfaces and side surfaces of the semiconductor light-emitting device chips 10. When the formation of the phosphor layer 55 is complete, the phosphor layer 55 is patterned to expose electrode pads 11 and 12 (refer to FIG. 1) on the top surfaces of the semiconductor light-emitting device chips 10. For example, a mask 160 formed of a film or a glass substrate having a pattern of a plurality of openings 161 for transmission of light may be disposed on the semiconductor light-emitting device chips 10 and then UV light may be irradiated thereto. Positions of the openings 161 may correspond to positions of the electrode pads 11 and 12. Then, the phosphor layer 55 on the electrode pads 11 and 12 may be exposed to the UV light and then removed. Thus, the electrode pads 11 and 12 of the semiconductor light-emitting device chips 10 may be externally exposed.

Next, as illustrated in FIG. 18 (d), by performing a dicing process, the phosphor layer 55 between the semiconductor light-emitting device chips 10, and the adhesion layer 111 below the semiconductor light-emitting device chips 10 are cut. Then, as illustrated in FIG. 18 (e), each semiconductor light-emitting device chip 10 may be separated from the carrier substrate 110 by using a holder 125. As described above, in a case where the adhesion layer 111 is formed of a PSA that is curable by UV light, before the semiconductor light-emitting device chips 10 are separated, the UV light is irradiated to a bottom surface of the carrier substrate 110 to harden the adhesion layer 111. When the adhesion layer 111 is hardened, the semiconductor light-emitting device chips 10 may be further easily separated from the adhesion layer 111. In a subsequent process, each of the separated semiconductor light-emitting device chips 10 is packaged to manufacture a white light-emitting device chip.

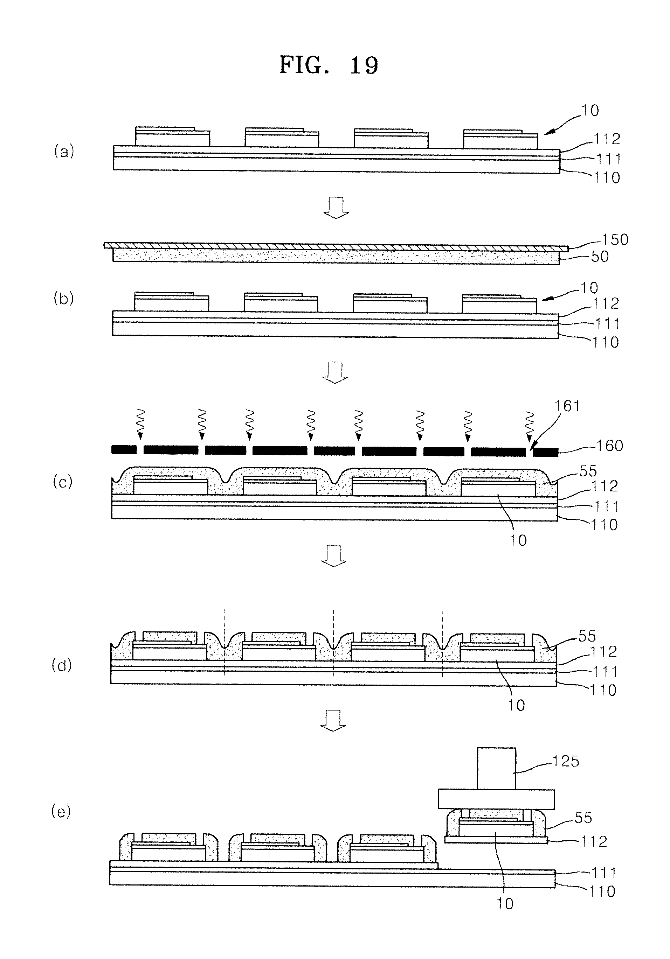

FIG. 19 illustrates a phosphor applying method according to another embodiment of the present invention. Referring to FIG. 19 (a), an adhesion layer 111 and an adhesive layer 112 are sequentially formed on a carrier substrate 110. Then, semiconductor light-emitting device chips 10 having the same light-emission characteristics are arrayed on the adhesive layer 112 at regular gaps. The adhesion layer 111 functions to temporarily fix the adhesive layer 112 thereon. Configurations and characteristics of the carrier substrate 110 and the adhesion layer 111 are the same as the descriptions above. Also, a configuration and characteristic of the adhesive layer 112 may be the same as those of the adhesive layer 112 described above with reference to FIG. 9.

Afterward, a phosphor may be applied around the semiconductor light-emitting device chips 10 in the same manner described with reference to FIG. 18. That is, as illustrated in FIG. 19 (b), a release film 150 having a phosphor film 50 adhered thereon is disposed above the semiconductor light-emitting device chips 10. After the release film 150 is disposed above the semiconductor light-emitting device chips 10, the phosphor film 50 is adhered on surfaces of the semiconductor light-emitting device chips 10 and the carrier substrate 110 by performing a laminating process. As described above, while the laminating process is performed, the release film 150 may be heated, and the laminating process may be performed in a vacuum atmosphere. Then, as illustrated in FIG. 19 (c), a phosphor layer 55 may be formed surrounding top surfaces and side surfaces of the semiconductor light-emitting device chips 10. When the formation of the phosphor layer 55 is complete, the phosphor layer 55 is patterned to expose electrode pads 11 and 12 on the top surfaces of the semiconductor light-emitting device chips 10. For example, UV is irradiated to the semiconductor light-emitting device chips 10 via a mask 160 having a plurality of openings 161. By doing so, the phosphor layer 55 on the electrode pads 11 and 12 may be exposed to the UV light and then removed.

Next, as illustrated in FIG. 19 (d), by performing a dicing process, the phosphor layer 55 between the semiconductor light-emitting device chips 10, and the adhesive layer 112 and the adhesion layer 111 below the semiconductor light-emitting device chips 10 are cut. Then, as illustrated in FIG. 19 (e), each semiconductor light-emitting device chip 10 may be separated from the carrier substrate 110 by using a holder 125. Here, the adhesive layer 112 is adhered on a bottom surface of each semiconductor light-emitting device chip 10. In a subsequent process, each of the separated semiconductor light-emitting device chips 10 is packaged to manufacture a white light-emitting device chip.

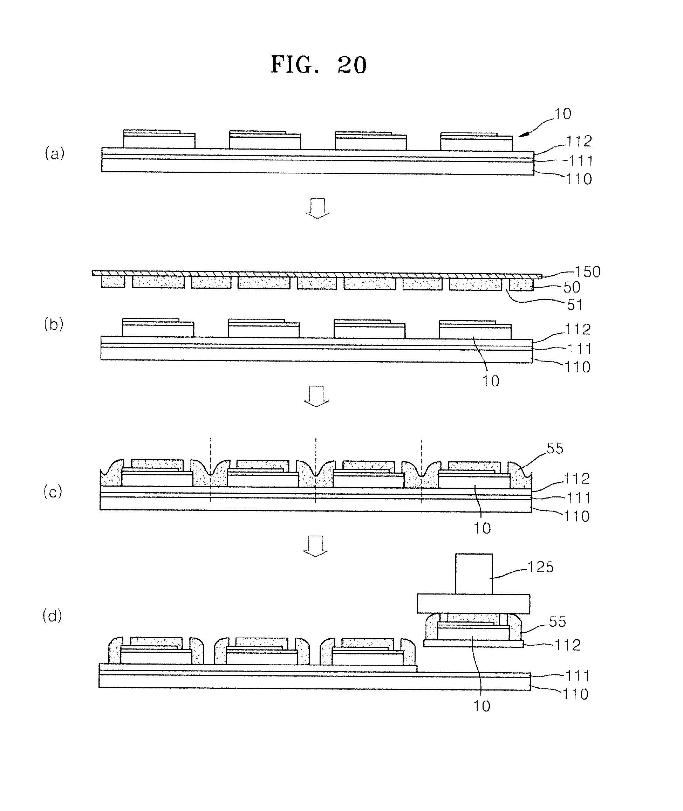

FIG. 20 illustrates a phosphor applying method according to another embodiment of the present invention. Referring to FIG. 20 (a), an adhesion layer 111 and an adhesive layer 112 are sequentially formed on a carrier substrate 110, and then, semiconductor light-emitting device chips 10 having the same light-emission characteristics are arrayed on the adhesive layer 112 at regular gaps. Referring to FIG. 20, the adhesive layer 112 is further arranged on the adhesion layer 111 but in the present embodiment, the adhesive layer 112 may be omitted. That is, similar to the embodiment of FIG. 18, the semiconductor light-emitting device chips 10 may be arrayed on the adhesion layer 111 without the adhesive layer 112.

Afterward, as illustrated in FIG. 20 (b), a release film 150 having a phosphor film 50 adhered thereon is disposed above the semiconductor light-emitting device chips 10. In the present embodiment, the phosphor film 50 is patterned to have openings 51 at positions corresponding to electrode pads 11 and 12 of the semiconductor light-emitting device chips 10. That is, a phosphor is not formed on the positions corresponding to electrode pads 11 and 12 of the semiconductor light-emitting device chips 10.

Afterward, as illustrated in FIG. 20 (c), the phosphor film 50 is adhered on surfaces of the semiconductor light-emitting device chips 10 and the carrier substrate 110 by performing a laminating process. By doing so, a phosphor layer 55 may be formed surrounding top surfaces and side surfaces of the semiconductor light-emitting device chips 10. In the present embodiment, the openings 51 are previously patterned at the positions corresponding to the electrode pads 11 and 12 of the semiconductor light-emitting device chips 10, so that the phosphor layer 55 is not formed on the electrode pads 11 and 12 of the semiconductor light-emitting device chips 10. Thus, it is not necessary to separately perform a process so as to expose the electrode pads 11 and 12.

Afterward, by performing a dicing process, the phosphor layer 55 between the semiconductor light-emitting device chips 10, and the adhesive layer 112 and the adhesion layer 111 below the semiconductor light-emitting device chips 10 are cut. Then, as illustrated in FIG. 20 (d), each semiconductor light-emitting device chip 10 may be separated from the carrier substrate 110 by using a holder 125. In a subsequent process, each of the separated semiconductor light-emitting device chips 10 is packaged to manufacture a white light-emitting device chip.

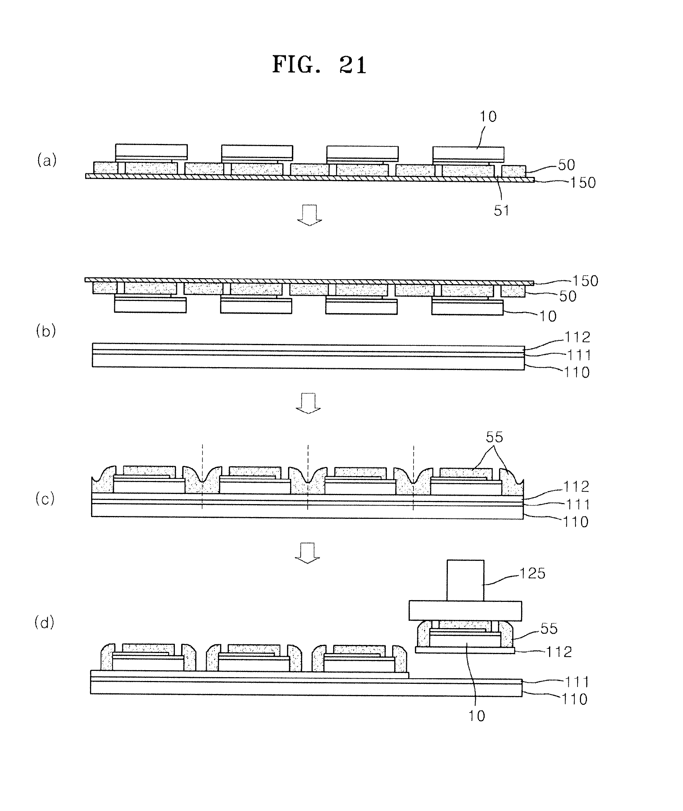

FIG. 21 illustrates a phosphor applying method according to another embodiment of the present invention. The embodiment of FIG. 21 is different from the previous embodiments in that semiconductor light-emitting device chips 10 are first arrayed on a phosphor film 50 that is patterned to have openings 51. That is, referring to FIG. 21 (a), the semiconductor light-emitting device chips 10 having the same light-emission characteristics are arrayed on the phosphor film 50 adhered on a release film 150. As described above, the phosphor film 50 is patterned to have the openings 51 at positions corresponding to electrode pads 11 and 12 of the semiconductor light-emitting device chips 10. That is, a phosphor is not formed on the positions corresponding to the electrode pads 11 and 12 of the semiconductor light-emitting device chips 10. The semiconductor light-emitting device chips 10 are arrayed so that top surfaces of the semiconductor light-emitting device chips 10 whereon the electrode pads 11 and 12 are formed contact the phosphor film 50. Here, the semiconductor light-emitting device chips 10 are aligned so that the electrode pads 11 and 12 of the semiconductor light-emitting device chips 10 correspond to the openings 51 of the phosphor film 50. According to the present embodiment, it is possible to avoid difficulty in simultaneously and exactly aligning the electrode pads 11 and 12 of the semiconductor light-emitting device chips 10 and the openings 51 of the phosphor film 50.

Afterward, as illustrated in FIG. 21 (b), the semiconductor light-emitting device chips 10 are disposed on the carrier substrate 110 whereon an adhesion layer 111 and an adhesive layer 112 are formed. In this process, the semiconductor light-emitting device chips 10 are disposed in a manner that bottom surfaces of the semiconductor light-emitting device chips 10 contact the adhesive layer 112. The phosphor film 50 and the release film 150 are still adhered on the top surfaces of the semiconductor light-emitting device chips 10. Referring to FIG. 21, the adhesive layer 112 is further arranged on the adhesion layer 111 but the adhesive layer 112 may be omitted. That is, the semiconductor light-emitting device chips 10 may be disposed on the adhesion layer 111 without the adhesive layer 112.

Afterward, the phosphor film 50 is adhered on surfaces of the semiconductor light-emitting device chips 10 and the carrier substrate 110 by performing a laminating process. By doing so, as illustrated in (c) of FIG. 21, a phosphor layer 55 may be formed surrounding top surfaces and side surfaces of the semiconductor light-emitting device chips 10. In the present embodiment, the openings 51 are previously patterned at the positions corresponding to the electrode pads 11 and 12 of the semiconductor light-emitting device chips 10, so that the phosphor layer 55 is not formed on the electrode pads 11 and 12 of the semiconductor light-emitting device chips 10. Thus, it is not necessary to separately perform a process so as to expose the electrode pads 11 and 12. Afterward, by performing a dicing process, the phosphor layer 55 between the semiconductor light-emitting device chips 10, and the adhesive layer 112 and the adhesion layer 111 below the semiconductor light-emitting device chips 10 are cut. Then, as illustrated in FIG. 21 (d), each semiconductor light-emitting device chip 10 may be separated from the carrier substrate 110 by using a holder 125. In a subsequent process, each of the separated semiconductor light-emitting device chips 10 is packaged to manufacture a white light-emitting device chip.

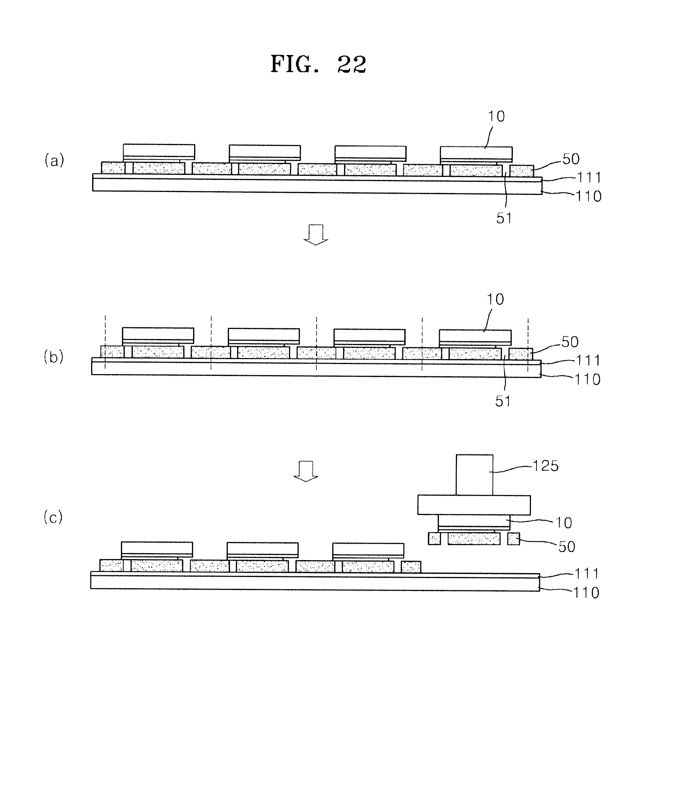

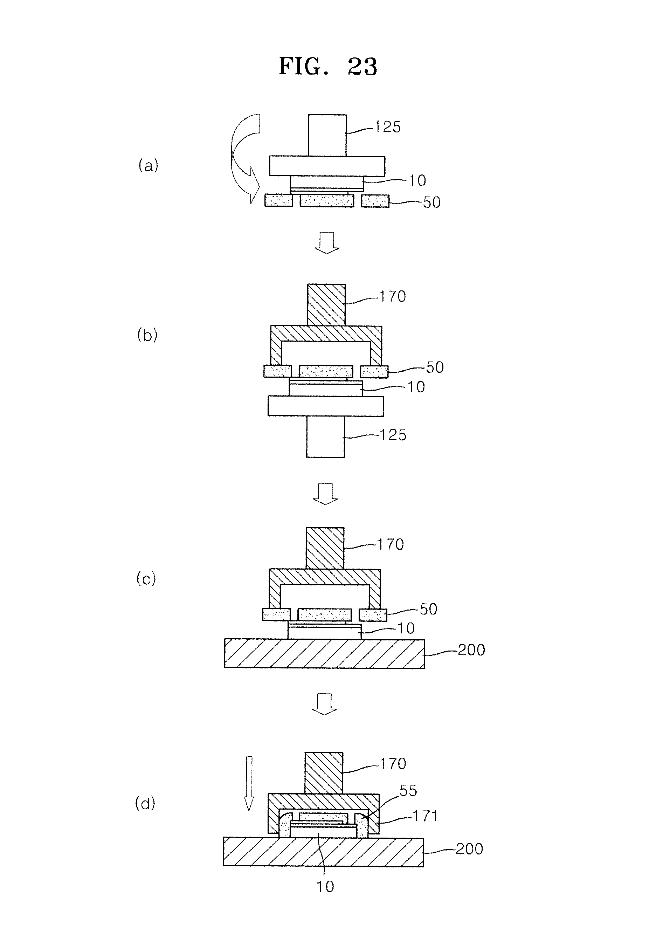

FIGS. 22 and 23 illustrate a phosphor applying method according to another embodiment of the present invention. The present embodiment of FIGS. 22 and 23 is different from the previous embodiments in that a laminating process may be omitted. First, referring to FIG. 22 (a), an adhesion layer 111 is formed on a carrier substrate 110, and a patterned phosphor film 50 is adhered on the adhesion layer 111. The phosphor film 50 is patterned to have openings 51 at positions corresponding to electrode pads 11 and 12 of the semiconductor light-emitting device chips 10. Afterward, the semiconductor light-emitting device chips 10 having the same light-emission characteristics are arrayed on the phosphor film 50. The semiconductor light-emitting device chips 10 are disposed so that top surfaces of the semiconductor light-emitting device chips 10 whereon the electrode pads 11 and 12 are formed contact the phosphor film 50. Here, the semiconductor light-emitting device chips 10 are aligned so that the electrode pads 11 and 12 of the semiconductor light-emitting device chips 10 correspond to the openings 51 of the phosphor film 50.

Next, as illustrated in FIG. 22 (b), by performing a dicing process, the phosphor film 50 between the semiconductor light-emitting device chips 10, and the adhesion layer 111 below the semiconductor light-emitting device chips 10 are cut. Then, as illustrated in FIG. 22 (c), each semiconductor light-emitting device chip 10 and the phosphor film 50 adhered thereto may be separated from the carrier substrate 110 by using a holder 125.

Afterward, sequentially referring to FIG. 23 (a), the holder 125 is vertically rotated so that the semiconductor light-emitting device chips 10 are disposed above the holder 125. Accordingly, the phosphor film 50 is positioned above the semiconductor light-emitting device chips 10. Then, as illustrated in FIG. 23 (b) and (c), a clamping device 170 lifts up each semiconductor light-emitting device chip 10 from the holder 125, and arranges each semiconductor light-emitting device chip 10 on a base substrate 200. The base substrate 200 may be a lead frame of a light-emitting device package, or may be a printed circuit board (PCB) having a predetermined wiring. A collet 171 having a hollow cavity may be arranged on a front end of the clamping device 170. The collet 171 may have a cavity having a shape corresponding to an outer frame shape of each semiconductor light-emitting device chip 10. Thus, after the semiconductor light-emitting device chips 10 are arrayed on the base substrate 200, as illustrated in FIG. 23 (d), the collet 171 presses down the phosphor film 50, each semiconductor light-emitting device chip 10 is accepted into the cavity of the collet 171, and the phosphor film 50 is pressed down by the collet 171, so that the phosphor film 50 may be coated on top surfaces and side surfaces of the semiconductor light-emitting device chips 10. Simultaneously, the phosphor film 50 may be hardened by irradiating heat or UV light thereto, so that a phosphor layer 55 may be formed on the top surfaces and side surfaces of the semiconductor light-emitting device chips 10.

It should be understood that the exemplary embodiments described therein should be considered in a descriptive sense only and not for purposes of limitation. Descriptions of features or aspects within each embodiment should typically be considered as available for other similar features or aspects in other embodiments.

## Claims

1. A method of applying a phosphor to a light-emitting device, the method comprising:
testing light-emission characteristics of a plurality of light-emitting devices formed on a wafer;
disposing a plurality of light-emitting devices having the same light-emission characteristics on a carrier substrate;
applying a same phosphor to the plurality of light-emitting devices disposed on the carrier substrate; and
separating the plurality of arrayed light-emitting devices.

2. The method of claim 1, wherein the testing of the light-emission characteristics comprises:
independently separating the plurality of light-emitting devices formed on the wafer from the wafer; and
testing a light-emission characteristic of each of the plurality of separated light-emitting devices,
wherein the light-emission characteristics comprise a light-emission spectrum and brightness.

3. The method of claim 1, wherein the carrier substrate has an adhesion layer formed on a top surface of the carrier substrate, and the plurality of light-emitting devices are disposed on the adhesion layer, wherein the adhesion layer comprises photosensitive adhesive (PSA) that is curable by ultraviolet (UV) light, and the carrier substrate has transmittance with respect to the UV light.

4. The method of claim 3, wherein the separating of the plurality of light-emitting devices comprises:
hardening the adhesion layer by irradiating the UV light to a bottom surface of the carrier substrate; and
separating each of the plurality of light-emitting devices by using a holder.

5. The method of claim 3, wherein the carrier substrate further has an adhesive layer disposed on a top surface of the adhesion layer, and the plurality of light-emitting devices are arrayed on the adhesive layer,
wherein the adhesive layer comprises a first adhesive layer disposed on the adhesion layer, a photo-reflection layer disposed on the first adhesive layer, and a second adhesive layer disposed on the photo-reflection layer.

6. The method of claim 5, wherein a white filler having thermal conductivity, or a filler coated by metal is dispersed in the first adhesive layer, the photo-reflection layer comprises a metal thin film, and the second adhesive layer has light-transmittance.

7. The method of claim 1, wherein the applying of the same phosphor comprises:
disposing a stencil mask above the plurality of light-emitting devices;
arranging a phosphor paste on the stencil mask; and
pressurizing the phosphor paste by using a squeeze, and uniformly applying the phosphor paste to top surfaces and side surfaces of the plurality of light-emitting devices,
wherein the stencil mask comprises a mesh structure designed to allow the phosphor paste to pass through the mesh structure, a masking member for masking the mesh structure, and one or more openings formed in the masking member.

8. The method of claim 7, wherein the masking member has a portion for contacting the carrier substrate, and another portion for contacting the electrode pads of each of the plurality of light-emitting devices, and wherein a height of the portion for contacting the carrier substrate is different from a height of the other portion for contacting the electrode pads of each of the plurality of light-emitting devices.

9. The method of claim 7, wherein a plurality of openings that respectively correspond to the plurality of light-emitting devices are formed in the masking member,
wherein a size of each of the plurality of openings is a value corresponding to a total sum of a size of each of the plurality of light-emitting devices and a thickness of the phosphor formed on side surfaces of each of the plurality of light-emitting devices.

10. The method of claim 7, wherein the stencil mask has one opening, and all of the plurality of light-emitting devices on the carrier substrate are positioned in the opening,
wherein the masking member is formed only at positions corresponding to electrode pads formed on the top surfaces of the plurality of light-emitting devices.

11. The method of claim 7, wherein the stencil mask has a plurality of openings, and a plurality of light-emitting devices are positioned in each of the plurality of openings.

12. The method of claim 1, wherein the applying of the same phosphor further comprises:
positioning a spray device above the plurality of light-emitting devices;
applying a phosphor paste to top surfaces and side surfaces of the plurality of light-emitting devices according to a spray coating way by sequentially moving the spray device above the plurality of light-emitting devices; and
hardening the phosphor paste applied to the top surfaces and the side surfaces of the plurality of light-emitting devices.

13. The method of claim 1, wherein the applying of the same phosphor further comprises:
disposing a release film having a phosphor film adhered thereon above the plurality of light-emitting devices;
applying a phosphor to top surfaces and side surfaces of the plurality of light-emitting devices by completely adhering the phosphor film that is on the release film on surfaces of the plurality of light-emitting devices and the carrier substrate by performing a laminating process; and
removing the phosphor applied to electrode pads that are formed on the top surfaces of the plurality of light-emitting devices,
wherein heat is applied to the phosphor film while the laminating process is performed,
wherein the laminating process is performed in a vacuum atmosphere.

14. The method of claim 13, wherein the removing of the phosphor comprises:
disposing a mask on the plurality of light-emitting devices, wherein the mask has a pattern of a plurality of openings at positions corresponding to the electrode pads; and
removing the phosphor applied to the electrode pads by irradiating UV light to the electrode pads through the mask.

15. The method of claim 13, wherein the phosphor film on the release film is patterned to have openings at positions corresponding to the electrode pads formed on the top surfaces of the plurality of light-emitting devices.
